# EUROPEAN PATENT SPECIFICATION

(11) **EP 3 958 293 B1**
(45) Date of publication and mention of the grant of the patent: **12.06.2024**
(21) Application number: 21802587.2
(22) Date of filing: 17.05.2021
(51) Int. Cl.: H10B 12/00, H01L 21/311, H01L 21/033, H01L 21/3065

(54) **METHOD FOR PREPARING A HOLE IN A SEMICONDUCTOR DEVICE**
VERFAHREN ZUR HERSTELLUNG EINES LOCHS IN EINER HALBLEITERBAUELEMENT
PROCÉDÉ DE PRÉPARATION D'UN TROU DANS UN DISPOSITIF SEMI-CONDUCTEUR.

(30) Priority: 22.05.2020 CN 202010442740
(43) Date of publication of application: 23.02.2022
(73) Proprietor: Changxin Memory Technologies, Inc., Hefei, Anhui 230601 (CN)
(72) Inventor: XIA, Jun, Hefei Anhui 230601 (CN); LIU, Tao, Hefei Anhui 230601 (CN); WAN, Qiang, Hefei Anhui 230601 (CN); KANG, Jungsu, Hefei Anhui 230601 (CN); ZHAN, Kangshu, Hefei Anhui 230601 (CN); LI, Sen, Hefei Anhui 230601 (CN)
(74) Representative: V.O.
(86) International application number: PCT/CN2021/094217
(87) International publication number: WO 2021/233269

(56) References cited:
- CN-A- 1 855 382
- CN-A- 101 030 530
- CN-A- 107 301 976
- CN-A- 108 717 936
- US-A1- 2014 151 327
- US-A1- 2018 090 491
- US-A1- 2019 157 095
- US-A1- 2019 157 095

## Description

### CROSS-REFERENCE TO RELATED APPLICATIONS

This application claims priority to Chinese Patent Application No. 202010442740.6, filed on May 22, 2020 and entitled "METHOD FOR PREPARING HOLE IN SEMICONDUCTOR DEVICE, METHOD FOR PREPARING SEMICONDUCTOR DEVICE, AND SEMICONDUCTOR DEVICE", the entire contents of which are incorporated herein by reference.

### TECHNICAL FIELD

The present application relates to the technical field of semiconductor devices, in particular to a method for preparing a hole in a semiconductor device, a method for preparing a semiconductor device.

### BACKGROUND

With the development of the semiconductor industry and the demand for improved portability, computing capability, storage capacity, energy efficiency and other factors in modern electronic equipment, the size of the semiconductor device continues to reduce.

The size reduction of the semiconductor device can be achieved by reducing the size of structures formed in the semiconductor device, for example, the size of a capacitance hole in a capacitor structure of a memory. However, if the size of a hole is relatively small, that is, if a depth-to-width ratio of the hole is relatively large, since the phenomenon of not being able to be etched through may occur due to the limitation of the process conditions, the subsequent process steps will be affected. However, if the size of the hole is increased, the demand for a semiconductor device having a small size cannot be met. US2019157095 and US2018090491 describe methods for patterning features of small critical dimensions.

### SUMMARY

In the embodiments of the present application, there is provided a method for preparing a hole in a semiconductor device, a method for preparing a semiconductor device, and a semiconductor device, so as to solve the problems in the related art that if the size of a capacitance hole is relatively small, the phenomenon of not being able to be etched through will occur, while if the size of the hole is increased, the demand for a semiconductor device having a small size cannot be met.

In a first aspect, an embodiment of the present application provides a method for preparing a hole in a semiconductor device, which includes the following operations.

A base to be etched is provided and a mask layer is formed on the base to be etched.

A first pattern layer arranged in an array is formed on the mask layer.

The mask layer is etched by using the first pattern layer as a mask to form a first hole and a second pattern layer.

A protective layer is deposited on a side of the second pattern layer away from the base to be etched, the protective layer simultaneously covering a side wall and a bottom portion of the first hole.

The protective layer which covers the bottom portion of the first hole is etched.

The base to be etched is etched by using the second pattern layer and the protective layer which covers the side wall of the first hole as a mask to form a second hole.

Herein, a critical dimension of the second hole is less than a critical dimension of the first hole.

Optionally, the second hole includes any one of a capacitance hole, a wire connection hole or a through hole.

Optionally, the second hole includes a capacitance hole. The base to be etched includes a capacitance hole base. The capacitance hole base includes a semiconductor substrate and a supporting layer formed on the semiconductor substrate. The operation that the base to be etched is provided and the mask layer is formed on the base to be etched includes the following operation.

A semiconductor substrate is provided, and a supporting layer and a mask layer are sequentially formed on the semiconductor substrate.

The operation that the base to be etched is etched by using the second pattern layer and the protective layer which covers the side wall of the first hole as the mask to form the second hole includes the following operation.

The supporting layer is etched to the semiconductor substrate by using the second pattern layer and the protective layer which covers the side wall of the first hole as a mask to form the capacitance hole.

Optionally, a material of the protective layer includes polycrystalline silicon.

Optionally, the operation that the protective layer is deposited on the side of the second pattern layer away from the base to be etched includes the following operation.

The protective layer is deposited on the side of the second pattern layer away from the base to be etched by using an atomic layer deposition process.

Optionally, before sequentially forming the supporting layer and the mask layer on the semiconductor substrate, the method further includes the following operation.

A plurality of electrode contact blocks are formed on the semiconductor substrate, in which two adjacent electrode contact blocks are isolated from one another by a block insulation structure.

Optionally, a vertical projection of the second hole in a plane in which the semiconductor substrate is located is within a vertical projection of each electrode contact block in the plane in which the semiconductor substrate is located.

Optionally, the protective layer is a single-layered protective layer.

In a second aspect, an embodiment of the present application further provides a method for preparing a semiconductor device, which includes the method for preparing the hole in the semiconductor device as described in the first aspect.

In a third aspect, an embodiment of the present application further provides a method for preparing a semiconductor device, which is obtained by the method for preparing the semiconductor device as described in the second aspect.

According to the method for preparing the hole in the semiconductor device, the method for preparing the semiconductor device, and the semiconductor device provided by the embodiments of the present application, a protective layer is deposited on a side of the second pattern layer away from the base to be etched and also covers the side wall of the first hole, so that the critical dimension of the first hole between two adjacent second pattern layers is reduced. When the base to be etched is etched by using the second pattern layer and the protective layer which covers the side wall of the first hole as a mask, the size of the second hole obtained in this case is relatively small. As such, the problem of not being able to be etched through due to a relatively large depth-to-width ratio of the first hole will not occur. Meanwhile, a smaller hole can be obtained to meet the demand for a semiconductor device having a small size, thereby improving the integration degree of the semiconductor device. Moreover, the process is simple.

### BRIEF DESCRIPTION OF THE DRAWINGS

FIG. 1 is a flowchart of a method for preparing a hole in a semiconductor device according to an embodiment of the present application;
FIG. 2 is a schematic diagram of a structure after a first pattern layer is formed according to an embodiment of the present application;
FIG. 3 is a schematic diagram of a structure after a first hole is formed according to an embodiment of the present application;
FIG. 4 is a schematic diagram of a structure after a protective layer is formed according to an embodiment of the present application;
FIG. 5 is a schematic diagram of a structure after a second hole is formed according to an embodiment of the present application;
FIG. 6 is a flowchart of another method for preparing a hole in a semiconductor device according to an embodiment of the present application;
FIG. 7 is a schematic diagram of another structure after a first pattern layer is formed according to an embodiment of the present application;
FIG. 8 is a schematic diagram of another structure after a first hole is formed according to an embodiment of the present application;
FIG. 9 is a schematic diagram of another structure after a protective layer is formed according to an embodiment of the present application; and
FIG. 10 is a schematic diagram of another structure after a second hole is formed according to an embodiment of the present application.

### DETAILED DESCRIPTION

The present application is further described in detail below in combination with the accompanying drawings and embodiments. It can be understood that the specific embodiments described here are merely to explain the present application but not intended to limit the present application. In addition, it should be noted that for ease of description, only part, rather than all, of structures related to the present application are illustrated only in the accompanying drawings.

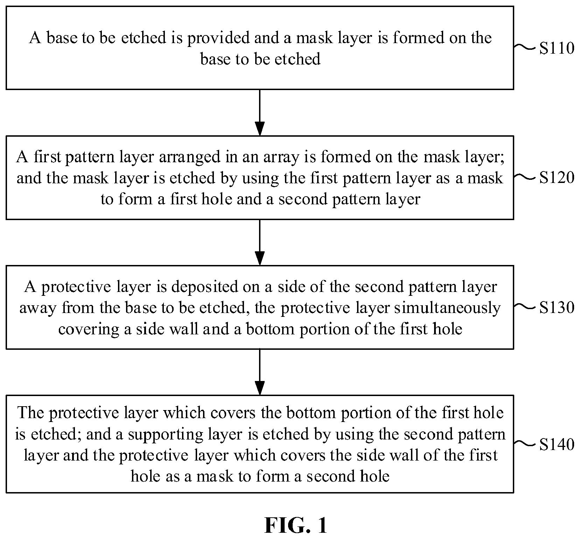

Based on the problems in the background, the embodiment of the present application provides a method for preparing a hole in a semiconductor device. FIG. 1 is a flowchart of a method for preparing a hole in a semiconductor device according to an embodiment of the present application. As shown in FIG. 1, the method for preparing the hole in the semiconductor device according to the embodiment of the present application includes the following operations.

In S 110, a base to be etched is provided and a mask layer is formed on the base to be etched.

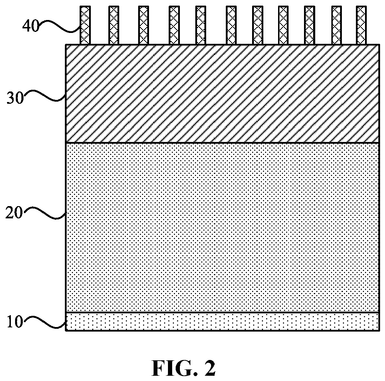

Referring to FIG. 2, the base 10 to be etched may include, for example, a capacitance hole base, a wire connection hole base, or a through hole base and other bases in the semiconductor device. The type of the base is not limited in this embodiment. Exemplarily, the base 10 to be etched includes a capacitance hole base. A mask layer 30 is used as a mask for subsequent etching of the base 10 to be etched. The thickness of the mask layer 30 is relatively large, so that the base 10 to be etched is subsequently etched by using the mask layer 30 as a mask, so as to subsequently form a second hole. Optionally, the mask layer 30 may be of a single-layered structure, or may be of a multilayered stack structure, which is not limited in this embodiment. The material of the mask layer is not limited in this embodiment, either.

In S120, a first pattern layer arranged an array is formed on the mask layer, and the mask layer is etched by using the first pattern layer as a mask to form a first hole and a second pattern layer.

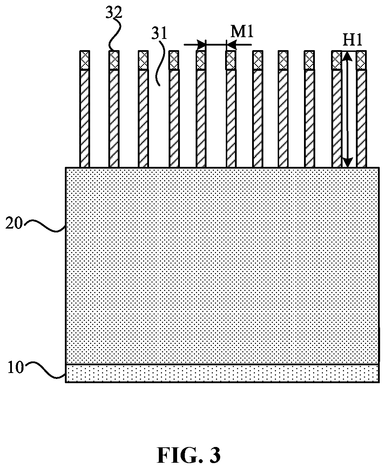

Referring to FIG. 2 and FIG. 3, specifically, a layer of photoresist layer can be firstly formed as the material of the first pattern layer 40. It can be understood that in other embodiments, a first pattern layer 40 of other materials can also be formed, such as a silicon nitride layer. Then, a layer of the material is patterned by adopting a photolithography process to obtain the first pattern layer 40. The first pattern layer 40 defines the position and shape of the first hole which is subsequently formed. Then, the mask layer 30 is etched by using the first pattern layer 40 as a mask, so as to form the first hole 31 and the second pattern layer 32 in the mask layer 30. Herein, the cross section of the first hole 31 may be, for example, of a circular shape, and the critical dimension of the first hole 31 is denoted as M1.

In S130, a protective layer is deposited on a side of the second pattern layer away from the base to be etched. The protective layer simultaneously covers a side wall and a bottom portion of the first hole.

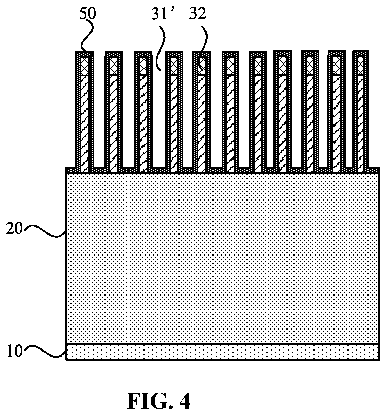

Referring to FIG. 4, the material of the protective layer 50 may be, for example, polycrystalline silicon or silicon nitride, which is not specifically limited in this embodiment as long as it is ensured that the etching selectivity between the protective layer 50 and the mask layer 30 is high. A layer of protective layer 50 can be deposited on the second pattern layer 32 by using an atomic layer deposition method or a chemical vapor deposition method. In the case that the material of the protective layer 50 is polycrystalline silicon and the protective layer is deposited by using the atomic layer deposition method, the deposition uniformity of the protective layer 50 is relatively good, so that in the subsequent process, the shape of the obtained second hole is more accurate. Optionally, the protective layer 50 is a single-layered or multilayered protective layer. If the protective layer 50 is a single layer, the demand for reducing the critical dimension of the first hole 31 can be met, without increasing the process steps. Optionally, the thickness of the protective layer 50 can be set according to an expected critical dimension of the second hole, which is not limited in this embodiment.

Specifically, considering that when the depth-to-width ratio of the first hole 31 is relatively large, that is, the critical dimension of the first hole 31 is relatively small, the problem of not being able to be etched through may probably occur, so that the subsequent process is affected. Therefore, in this embodiment, after ensuring that the first hole 31 is fully etched, in this case, the distance between the second pattern layers 32 (i.e., the critical dimension of the first hole 31) is relatively large, a layer of protective layer 50 is deposited on a side of the second pattern layer 32 away from the base 10 to be etched. The protective layer 50 covers the side wall and the bottom portion of the first hole 31, thereby obtaining a new first hole 31'. In this case, the critical dimension of the new first hole 31' is relatively small. The critical dimension of the new first hole 31' is an expected critical dimension. That is, an expected second hole can be obtained by using the second pattern layer and the protective layer on both sides of the new first hole 31' as a mask, and then a corresponding structure can be prepared in the second hole, thereby obtaining a corresponding semiconductor device. In this case, the obtained semiconductor device meets the demand for a semiconductor device having a small size.

In S140, the protective layer which covers the bottom portion of the first hole is etched, and the base to be etched is etched by using the second pattern layer and the protective layer which covers the side wall of the first hole as a mask to form a second hole. The critical dimension of the second hole is less than the critical dimension of the first hole.

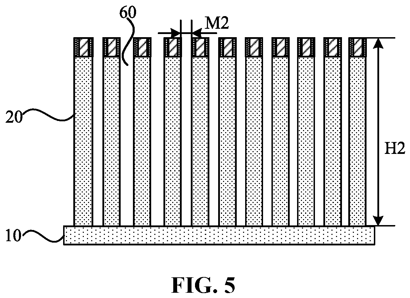

Referring to FIG. 4 and FIG. 5, specifically, compared with using the second pattern layer 32 as a mask, etching a supporting layer 20 by using the second pattern layer 32 and the protective layer 50 which covers the side wall of the first hole 31 as a mask to form a second hole 60 reduces the critical dimension of the second hole 60. As such, it is possible to ensure that the first hole 31 is fully etched, and meanwhile a smaller second hole 60 can also be obtained to meet the demand for a semiconductor device having a small size, thereby improving the integration degree of the semiconductor device.

In summary, according to the method for preparing the hole in the semiconductor device provided by the embodiments of the present application, a protective layer is deposited on a side of the second pattern layer away from the base to be etched and covers the side wall of the first hole, so that the critical dimension of the first hole between two adjacent second pattern layers is reduced. When the base to be etched is etched by using the second pattern layer and the protective layer which covers the side wall of the first hole as a mask, the size of the obtained second hole is relatively small. As such, the problem of not being able to be etched through due to a relatively large depth-to-width ratio of the first hole will not occur. Meanwhile, a relatively small hole can be obtained to meet the demand for a semiconductor device having a small size, thereby improving the integration degree of the semiconductor device. Moreover, the process is simple.

On the basis of the above solution, continuously referring to FIG.3, the depth-to-width ratio of the first hole 31 is denoted as A, in which 8≤A ≤20.

According to the invention, the depth-to-width ratio of the first hole 31 is A=H1/M1. When the depth-to-width ratio of the first hole 31 is greater than or equal to 8 and less than or equal to 20, it is ensured that the first hole 31 is fully etched, and the problem that the first hole 31 cannot be etched through to affect the subsequent process is avoided.

Continuously, referring to FIG. 3, a part of the first pattern layer 40 can be reserved to ensure that the depth-to-width ratio of the first hole 31 is greater than or equal to 8 and less than or equal to 20, so as to prevent over-etching when the base 10 to be etched is etched to affect the subsequent process. Optionally, continuously referring to FIG. 5, the aperture of the second hole 60 is denoted as B, in which B< 100 nm.

In this embodiment, when the aperture of the second hole 60 is less than 100 nm, i.e., the critical dimension of the second hole 60 is relatively small, the integration degree of the semiconductor device is improved.

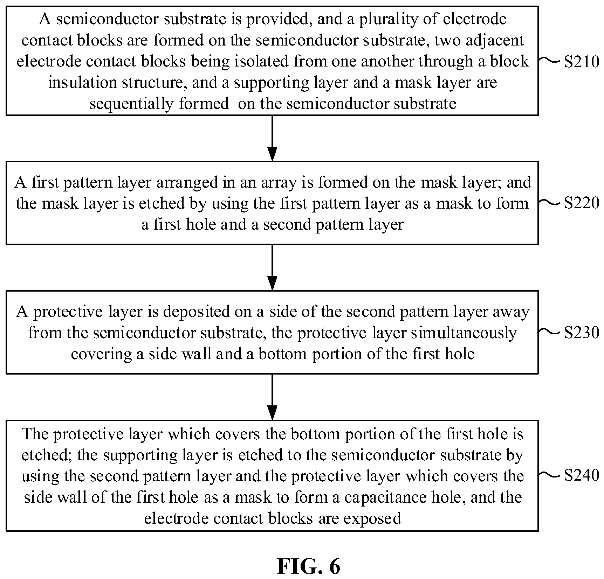

Optionally, FIG. 6 is a flowchart of another method for preparing a hole in a semiconductor device according to an embodiment of the present application, exemplarily illustrating a specific process in the case that "the hole in the semiconductor device is a capacitance hole". As shown in FIG. 6, the method for preparing a hole in a semiconductor includes the following operations.

In S210, a semiconductor substrate is provided, and a plurality of electrode contact blocks are formed on the semiconductor substrate. Two adjacent electrode contact blocks are isolated from one another by a block insulation structure. And a supporting layer and a mask layer are sequentially formed on the semiconductor substrate.

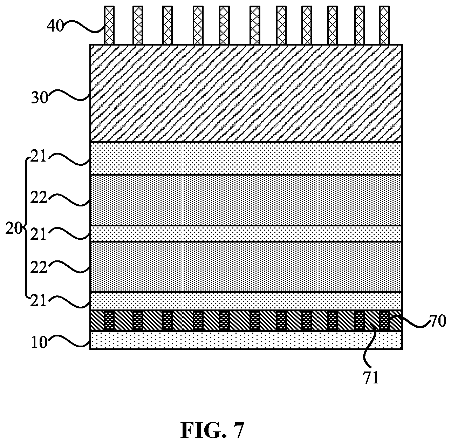

Referring to FIG. 7, a material of the semiconductor substrate 10 may be silicon, germanium, silicon-cadmium, and silicon carbide, or may be silicon on insulator or germanium on insulator, or group III-V compound such as gallium arsenide, etc., which is not specifically limited in this embodiment. Optionally, the semiconductor substrate 10 is provided with a semiconductor device (not shown in the figure). The semiconductor device may include, for example, a transistor and/or a capacitor. The semiconductor substrate 10 is also provided with a metal interconnection wire, etc. (not shown in the figure). The electronic contact blocks 70 are used to connect the lower electrode layer of the capacitor subsequently formed. By means of the electrode contact blocks 70, data stored in the capacitor can be read or data can be written to the capacitor. The arrangement of the electrode contact blocks 70 is the same as the arrangement of the second holes subsequently formed, i.e., the arrangement of the capacitance holes. Exemplarily, the electrode contact blocks 70 may be arranged in a hexagonal array. A material of each electrode contact block 70 may be, for example, metal. Exemplarily, the material of each electrode contact block 70 is tungsten, copper, aluminum, etc. The supporting layer 20 is used to define a main structure of the semiconductor device subsequently formed. For example, a capacitance hole is subsequently formed in the supporting layer 20, and an upper electrode layer and a lower electrode layer of the capacitor and a capacitance dielectric layer are formed in the capacitance hole. That is, the supporting layer 20 defines the depth of the capacitance hole and the heights of the upper electrode layer and the lower electrode layer of the capacitor. The supporting layer 20 may be, for example, of a laminated structure including a sacrificial unit 22 and a supporting unit 21 which are alternately stacked on one another. As such, a second hole 60 with a larger depth-to-width ratio can be obtained, thereby greatly increasing the capacitance value per unit area and improving the integration degree and performance of the storage device. A material of the sacrificial unit 22 may include, for example, silicon oxide, silicon nitride or polycrystalline silicon. The sacrificial unit 22 can also be doped with boron or phosphorus, so that the uniformity of the critical dimension can be guaranteed, and the removal rate of the sacrificial unit can be increased. A material of the supporting unit 21 may be any one or a combination of silicon nitride and silicon oxynitride. The sacrificial unit 22 will be removed in the subsequent process. The supporting unit 21 is used as a supporting frame in the subsequent process after the sacrificial unit 22 is removed, so that the mechanical strength of a structure during subsequent manufacturing of the capacitor can be greatly enhanced, and damage to the capacitor in the subsequent process can also be avoided. Optionally, the number of the supporting units 21 and the number of the sacrificial units 22 may be set according to the required height of the subsequent capacitor. For example, referring to FIG. 7, the number of the supporting units 21 is three, and the number of the sacrificial units 22 is two.

In S220, a first pattern layer arranged in an array is formed on the mask layer, and the mask layer is etched by using the first pattern layer as a mask to form a first hole and a second pattern layer.

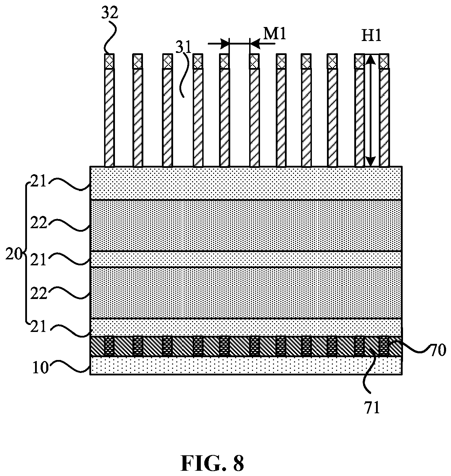

Referring to FIG. 7 and FIG. 8, specifically, the mask layer 30 is etched by using the first pattern layer 40 as a mask, so as to form a first hole 31 and a second pattern layer 32 in the mask layer 30.

In S230, a protective layer is deposited on a side of the second pattern layer away from the semiconductor substrate. The protective layer simultaneously covers the side wall and the bottom portion of the first hole.

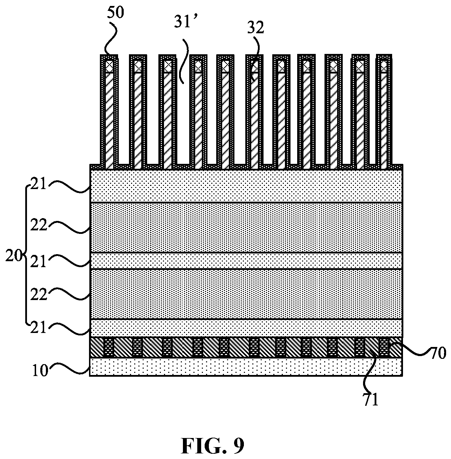

Referring to FIG. 9, specifically, considering that when the depth-to-width ratio of the first hole 31 is relatively large, that is, the critical dimension of the first hole 31 is relatively small, a capacitor with a smaller size is obtained, and the problem of not being able to be etched through may probably occur, so that the subsequent process is affected. Therefore, in this embodiment, after ensuring that the first hole 31 is fully etched, in this case, the distance between the second pattern layers 32 (i.e., the critical dimension of the first hole 31) is relatively large, and a layer of protective layer 50 is deposited on a side of the second pattern layer 32 away from the semiconductor substrate 10. The protective layer 50 covers the side wall and the bottom portion of the first hole 31, thereby obtaining a new first hole 31'. In this case, the critical dimension of the new first hole 31' is relatively small. The critical dimension of the new first hole 31' is an expected critical dimension. That is, an expected second hole 60 (i.e., a capacitance hole) can be obtained by using the second pattern layer and the protective layer on both sides of the new first hole 31' as a mask , and a corresponding structure can be prepared in the capacitance hole. For example, a lower electrode layer, a capacitance dielectric layer, etc. are formed in the capacitance hole to obtain the capacitor. In this case, the obtained capacitor has a relatively small size, so that the integration degree of the storage device is improved.

In S240, the protective layer which covers the bottom portion of the first hole is etched; and the supporting layer is etched to the semiconductor substrate by using the second pattern layer and the protective layer which covers the side wall of the first hole as a mask to form the capacitance hole, and the electrode contact blocks are exposed. The critical dimension of the second hole is less than the critical dimension of the first hole.

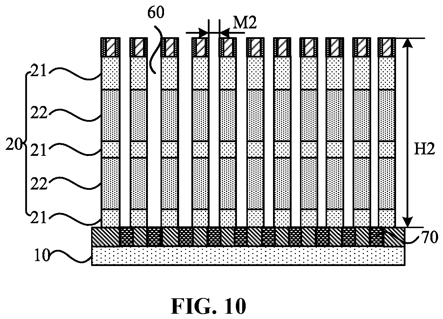

On the basis of the above solution, optionally, continuously referring to FIG. 10, a vertical projection of the second hole 60 in a plane in which the semiconductor substrate 10 is located is within a vertical projection of each electrode contact block 70 in the plane in which the semiconductor substrate 10 is located.

In this embodiment, when the vertical projection of the second hole 60 in the plane in which the semiconductor substrate 10 is located is within the vertical projection of each electrode contact block 70 in the plane in which the semiconductor substrate 10 is located, it is ensured that the lower electrodes subsequently formed are in sufficient contact with the electrode contact blocks 70, thereby increasing the speed of reading data stored in the capacitor or writing data to the capacitor by means of the electrode contact blocks 70.

In this embodiment, a protective layer is deposited on a side of the second pattern layer away from the semiconductor substrate and covers the side wall of the first hole, so that the critical dimension of the first hole between two adjacent second pattern layers is reduced. When the supporting layer is etched by using the second pattern layer and the protective layer which covers the side wall of the first hole as a mask, the size of the capacitance hole obtained in this case is relatively small. As such, the problem of not being able to be etched through due to a relatively large depth-to-width ratio of the first hole will not occur. Meanwhile, a relatively small capacitance hole can also be obtained, thereby improving the integration degree of a semiconductor memory. Moreover, the process is simple.

Based on the same application concept, the embodiment of the present application further provides a method for preparing a semiconductor device, which includes the method for preparing the hole in the semiconductor device described in the above-mentioned embodiments. Since the method for preparing the semiconductor memory in this embodiment and the method for preparing the hole in the semiconductor device described in the above-mentioned embodiments belong to the same application concept, the details that are not described in the embodiment of the method for preparing the semiconductor device can refer to the above-mentioned embodiments of the method for preparing the hole in the semiconductor device.

It should be noted that the above descriptions are merely the preferred embodiments of the present application and the applied technical principles. Those skilled in the art can understand that the present application is not limited to the specific embodiments described herein, and those skilled in the art can make various obvious modifications, readjustments and substitutions without departing from the protection scope of the present application. Therefore, although the present application has been described in detail through the above embodiments, the present application is not limited to the above embodiments, and may include other equivalent embodiments without departing from the concept of the present application. The scope of the present application is determined by the scope of the appended claims.

## Claims

1. A method for preparing a hole in a semiconductor device, comprising:
providing (S110) a base (10) to be etched and forming a mask layer (30) on the base (10) to be etched;
forming (S120) a first pattern layer (40) arranged in an array on the mask layer (30); and etching the mask layer (30) by using the first pattern layer (40) as a mask to form a first hole (31) and a second pattern layer (32);
depositing (S130) a protective layer (50) on a side of the second pattern layer (32) away from the base (10) to be etched, the protective layer (50) simultaneously covering a side wall and a bottom portion of the first hole (31);
etching (S140) the protective layer (50) which covers the bottom portion of the first hole (31); and etching the base (10) to be etched by using the second pattern layer (32) and the protective layer (50) which covers the side wall of the first hole (31) as a mask to form a second hole (60),
wherein a critical dimension of the second hole (60) is less than a critical dimension of the first hole (31),
**characterized in that** a depth-to-width ratio of the first hole (31) is greater than or equal to 8 and less than or equal to 20.

2. The method for preparing the hole in the semiconductor device of claim 1, wherein the second hole (60) comprises any one of a capacitance hole, a wire connection hole or a through hole.

3. The method for preparing the hole in the semiconductor device of claim 1, wherein the second hole (60) comprises a capacitance hole, the base (10) to be etched comprises a capacitance hole base, and the capacitance hole base comprises a semiconductor substrate and a supporting layer (20) formed on the semiconductor substrate;
wherein providing the base (10) to be etched and forming the mask layer (30) on the base (10) to be etched comprises:
providing a semiconductor substrate, and sequentially forming a supporting layer (20) and a mask layer (30) on the semiconductor substrate;
wherein etching the base (10) to be etched by using the second pattern layer (32) and the protective layer (50) which covers the side wall of the first hole (31) as the mask to form the second hole (60) comprises:
etching the supporting layer (20) to the semiconductor substrate by using the second pattern layer (32) and the protective layer (50) which covers the side wall of the first hole (31) as a mask to form the capacitance hole.

4. The method for preparing the hole in the semiconductor device of claim 1, wherein a material of the protective layer (50) comprises polycrystalline silicon.

5. The method for preparing the hole in the semiconductor device of claim 1, wherein depositing the protective layer (50) on the side of the second pattern layer (32) away from the base (10) to be etched comprises:
depositing the protective layer (50) on the side of the second pattern layer (32) away from the base (10) to be etched by using an atomic layer deposition process.

6. The method for preparing the hole in the semiconductor device of claim 3, wherein before sequentially forming the supporting layer (20) and the mask layer (30) on the semiconductor substrate, the method further comprises:
forming a plurality of electrode contact blocks (70) on the semiconductor substrate, two adjacent electrode contact blocks (70) being isolated from one another by a block insulation structure.

7. The method for preparing the hole in the semiconductor device of claim 6, wherein a vertical projection of the second hole (60) in a plane in which the semiconductor substrate is located is within a vertical projection of each electrode contact block (70) in the plane in which the semiconductor substrate is located.

8. The method for preparing the hole in the semiconductor device of claim 1, wherein the protective layer (50) is a single-layered protective layer.

9. The method for preparing the hole in the semiconductor device of claim 1, wherein an aperture of the second hole (60) is less than 100 nm.

10. A method for preparing a semiconductor device, **characterized in that** the method for preparing the semiconductor device comprises the method for preparing the hole in the semiconductor device according to any one of claims 1 to 5, 8 and 9.

## Patentansprüche

1. Verfahren zum Herstellen eines Lochs in einer Halbleitervorrichtung, das Folgendes umfasst:
Bereitstellen (S110) einer Basis (10) die geätzt werden soll, und Bilden einer Maskenschicht (30) auf der Basis (10), die geätzt werden soll;
Bilden (S120) einer ersten Strukturschicht (40), die in einer Anordnung auf der Maskenschicht (30) eingerichtet ist; und Ätzen der Maskenschicht (30) unter Verwendung der ersten Strukturschicht (40) als eine Maske, um ein erstes Loch (31) und eine zweite Strukturschicht (32) zu bilden;
Abscheiden (S130) einer Schutzschicht (50) auf einer Seite der zweiten Strukturschicht (32), von der Basis (10), die geätzt werden soll, entfernt, wobei die Schutzschicht (50) gleichzeitig eine Seitenwand und einen Bodenabschnitt des ersten Lochs (31) abdeckt;
Ätzen (S140) der Schutzschicht (50), die den Bodenabschnitt des ersten Lochs (31) abdeckt; und Ätzen der Basis (10), die geätzt werden soll, unter Verwendung der zweiten Strukturschicht (32) und der Schutzschicht (50), die die Seitenwand des ersten Lochs (31) abdeckt, als eine Maske, um ein zweites Loch (60) zu bilden,
wobei ein kritisches Maß des zweiten Lochs (60) kleiner ist als ein kritisches Maß des ersten Lochs (31),
**dadurch gekennzeichnet, dass** ein Tiefen-zu-Breiten-Verhältnis des ersten Lochs (31) größer oder gleich 8 und kleiner oder gleich 20 ist.

2. Verfahren zum Herstellen des Lochs in der Halbleitervorrichtung nach Anspruch 1, wobei das zweite Loch (60) eines von einem Kapazitätsloch, einem Drahtanschlussloch oder einem Durchgangslochs umfasst.

3. Verfahren zum Herstellen des Lochs in der Halbleitervorrichtung nach Anspruch 1, wobei das zweite Loch (60) ein Kapazitätsloch umfasst, wobei die Basis (10), die geätzt werden soll, eine Kapazitätslochbasis umfasst, und die Kapazitätslochbasis ein Halbleitersubstrat und eine Tragschicht (20), die auf dem Halbleitersubstrat gebildet ist, umfasst;
wobei das Bereitstellen der Basis (10), die geätzt werden soll, und das Bilden der Maskenschicht (30) auf der Basis (10), die geätzt werden soll, Folgendes umfasst:
Bereitstellen eines Halbleitersubstrats und sequenzielles Bilden einer Tragschicht (20) und einer Maskenschicht (30) auf dem Halbleitersubstrat;
wobei das Ätzen der Basis (10), die geätzt werden soll, unter Verwendung der zweiten Strukturschicht (32) und der Schutzschicht (50), die die Seitenwand des ersten Lochs (31) als die Maske abdeckt, um das zweite Loch (60) zu bilden, Folgendes umfasst:
Ätzen der Tragschicht (20) auf dem Halbleitersubstrat unter Verwendung der zweiten Strukturschicht (32) und der Schutzschicht (50), die die Seitenwand des ersten Lochs (31) abdeckt, als eine Maske, um das Kapazitätsloch zu bilden.

4. Verfahren zum Herstellen des Lochs in der Halbleitervorrichtung nach Anspruch 1, wobei ein Material der Schutzschicht (50) polykristallines Silizium umfasst.

5. Verfahren zum Herstellen des Lochs in der Halbleitervorrichtung nach Anspruch 1, wobei das Abscheiden der Schutzschicht (50) auf der Seite der zweiten Strukturschicht (32) von der Basis (10), die geätzt werden soll, entfernt, Folgendes umfasst:
Abscheiden der Schutzschicht (50) auf der Seite der zweiten Strukturschicht (32) von der Basis (10), die geätzt werden soll, entfernt, unter Verwendung eines Atomschichtabscheidungsverfahrens.

6. Verfahren zum Herstellen des Lochs in der Halbleitervorrichtung nach Anspruch 3, wobei vor dem sequenziellen Bilden der Tragschicht (20) und der Maskenschicht (30) auf dem Halbleitersubstrat, das Verfahren ferner Folgendes umfasst:
Bilden einer Vielzahl von Elektrodenkontaktblöcken (70) auf dem Halbleitersubstrat, wobei zwei aneinandergrenzende Elektrodenkontaktblöcke (70) voneinander durch eine Blockisolationsstruktur isoliert sind.

7. Verfahren zum Herstellen des Lochs in der Halbleitervorrichtung nach Anspruch 6, wobei ein vertikaler Vorsprung des zweiten Lochs (60) in einer Ebene, in der sich das Halbleitersubstrat befindet, innerhalb eines vertikalen Vorsprungs jedes Elektrodenkontaktblocks (70) in der Ebene befindet, in der sich das Halbleitersubstrat befindet,

8. Verfahren zum Herstellen des Lochs in der Halbleitervorrichtung nach Anspruch 1, wobei die Schutzschicht (50) eine einschichtige Schutzschicht ist.

9. Verfahren zum Herstellen des Lochs in der Halbleitervorrichtung nach Anspruch 1, wobei eine Öffnung des zweiten Lochs (60) kleiner ist als 100 nm.

10. Verfahren zum Herstellen einer Halbleitervorrichtung, **dadurch gekennzeichnet, dass** das Verfahren zum Herstellen der Halbleitervorrichtung das Verfahren zum Herstellen des Lochs in der Halbleitervorrichtung nach einem der Ansprüche 1 bis 5, 8 und 9 umfasst.

## Revendications

1. Procédé de préparation d'un trou dans un dispositif à semi-conducteurs, comprenant :
de fournir (S110) une base (10) à graver et de former une couche de masque (30) sur la base (10) à graver ;
de former (S120) une première couche de motif (40) agencée en réseau sur la couche de masque (30) ; et de graver la couche de masque (30) en utilisant la première couche de motif (40) comme masque pour former un premier trou (31) et une deuxième couche de motif (32) ;
de déposer (S130) une couche protectrice (50) sur un côté de la deuxième couche de motif (32) loin de la base (10) à graver, la couche protectrice (50) recouvrant simultanément une paroi latérale et une partie inférieure du premier trou (31) ;
de graver (S140) la couche protectrice (50) qui recouvre la partie inférieure du premier trou (31) ; et de graver la base (10) à graver en utilisant la deuxième couche de motif (32) et la couche protectrice (50) qui recouvre la paroi latérale du premier trou (31) comme masque pour former un deuxième trou (60),
dans lequel une dimension critique du deuxième trou (60) est inférieure à une dimension critique du premier trou (31),
**caractérisé en ce qu'**un rapport profondeur/largeur du premier trou (31) est supérieur ou égal à 8 et inférieur ou égal à 20.

2. Procédé de préparation du trou dans le dispositif à semi-conducteurs selon la revendication 1, dans lequel le deuxième trou (60) comprend l'un quelconque parmi un trou de capacité, un trou de connexion de fil ou un trou traversant.

3. Procédé de préparation du trou dans le dispositif à semi-conducteurs selon la revendication 1, dans lequel le deuxième trou (60) comprend un trou de capacité, la base (10) à graver comprend une base de trou de capacité, et la base de trou de capacité comprend un substrat semi-conducteur et une couche de support (20) formée sur le substrat semi-conducteur ;
dans lequel la fourniture de la base (10) à graver et la formation de la couche de masque (30) sur la base (10) à graver comprennent :
de fournir un substrat semi-conducteur, et de former séquentiellement une couche de support (20) et une couche de masque (30) sur le substrat semi-conducteur ;
dans lequel la gravure de la base (10) à graver en utilisant la deuxième couche de motif (32) et la couche protectrice (50) qui recouvre la paroi latérale du premier trou (31) comme masque pour former le deuxième trou (60) comprend :
de graver la couche de support (20) sur le substrat semi-conducteur en utilisant la deuxième couche de motif (32) et la couche protectrice (50) qui recouvre la paroi latérale du premier trou (31) comme masque pour former le trou de capacité.

4. Procédé de préparation du trou dans le dispositif à semi-conducteurs selon la revendication 1, dans lequel un matériau de la couche protectrice (50) comprend le silicium polycristallin.

5. Procédé de préparation du trou dans le dispositif à semi-conducteurs selon la revendication 1, dans lequel le dépôt de la couche protectrice (50) sur le côté de la deuxième couche de motif (32) loin de la base (10) à graver comprend :
de déposer la couche protectrice (50) sur le côté de la deuxième couche de motif (32) loin de la base (10) à graver en utilisant un processus de dépôt par couche atomique.

6. Procédé de préparation du trou dans le dispositif à semi-conducteurs selon la revendication 3, dans lequel avant de former séquentiellement la couche de support (20) et la couche de masque (30) sur le substrat semi-conducteur, le procédé comprend en outre :
de former une pluralité de blocs de contact d'électrode (70) sur le substrat semi-conducteur, deux blocs de contact d'électrode (70) adjacents étant isolés l'un de l'autre par une structure d'isolation de bloc.

7. Procédé de préparation du trou dans le dispositif à semi-conducteurs selon la revendication 6, dans lequel une projection verticale du deuxième trou (60) dans un plan dans lequel se trouve le substrat semi-conducteur se situe à l'intérieur d'une projection verticale de chaque bloc de contact d'électrode (70) dans le plan dans lequel se trouve le substrat semi-conducteur.

8. Procédé de préparation du trou dans le dispositif à semi-conducteurs selon la revendication 1, dans lequel la couche protectrice (50) est une couche protectrice monocouche.

9. Procédé de préparation du trou dans le dispositif à semi-conducteurs selon la revendication 1, dans lequel une ouverture du deuxième trou (60) est inférieure à 100 nm.

10. Procédé de préparation d'un dispositif à semi-conducteurs, **caractérisé en ce que** le procédé de préparation du dispositif à semi-conducteurs comprend le procédé de préparation du trou dans le dispositif à semi-conducteurs selon l'une quelconque des revendications 1 à 5, 8 et 9.
